# EUROPÄISCHE PATENTSCHRIFT

(11) **EP 2 994 243 B1**
(45) Veröffentlichungstag und Bekanntmachung des Hinweises auf die Patenterteilung: **22.06.2022**
(21) Anmeldenummer: 14730738.3
(22) Anmeldetag: 24.04.2014
(51) Int. Cl.: C09D 5/28, C09D 5/29, B05D 3/06, B05D 5/06, B05D 7/02, B05D 7/14, C23C 14/34, C23C 14/00, F24B 7/00, F24B 9/00

(54) **GLANZGRADEINSTELLUNG VON KUNSTSTOFFSUBSTRATEN MIT METALLISCHEM FINISH**
GLOSS DEGREE ADJUSTMENT OF PLASTICS SUBSTRATES HAVING A METALLIC FINISH
RÉGULATION DU DEGRÉ DE BRILLANCE DE SUBSTRATS EN MATIÈRE PLASTIQUE À FINITION MÉTALLIQUE

(30) Priorität: 10.05.2013 DE 102013007926
(43) Veröffentlichungstag der Anmeldung: 16.03.2016
(73) Patentinhaber: Oerlikon Surface Solutions AG, Pfäffikon, 8808 Pfäffikon (CH)
(72) Erfinder: SCHAEFER, Rüdiger, 79865 Grafenhausen (DE); ROSEZIN, Marc, 72488 Sigmaringen-Oberschmeien (DE); WEHRLE, Johannes, 72505 Krauchenwies (DE)
(74) Vertreter: Misselhorn, Hein-Martin
(86) Internationale Anmeldenummer: PCT/EP2014/001092
(87) Internationale Veröffentlichungsnummer: WO 2014/180537

(56) Entgegenhaltungen:
- EP-A1- 0 706 834
- EP-A1- 1 780 311
- EP-A1- 2 537 406
- EP-A2- 2 093 267
- EP-A2- 2 147 956
- DE-U1-202013 010 250

## Beschreibung

Die vorliegende Erfindung betrifft ein Verfahren zur Glanzgradeinstellung von Kunststoffsubstraten mit metallischem Finish. Solche Kunststoffsubstrate kommen zum Beispiel im Automotive-Bereich als Zierleisten, Kühlergrills, Aussenspiegel oder Emblems im Aussenbereich eines Kraftahrzeuges zum Einsatz. Auch im Innenbereich eines Kraftfahrzeuges werden zunehmend die vollmetallischen Komponenten durch Kunststoffkomponenten ersetzt, welche eine Beschichtung tragen, die ihnen metallisches Aussehen verleiht. Zu den bekannten und typischen Beschichtungsverfahren zählt die Galvanik. Diese geht aber mit einer erheblichen Umweltbelastung einher, so dass es starke Bestrebungen gibt, in diesem Bereich die Galvanikverfahren durch andere Methoden zu ersetzen.

Ein anderer Ansatz besteht darin, die Kunststoffsubstrate zunächst mit einer Basislackschicht (Basecoat) zu beschichten und diese anschliessend mit einer aus der Gasphase abgeschiedenen Metallschicht zu überziehen. In der EP 1 736 566 ist ein dementsprechendes Verfahren beschrieben. Hier wird auf ein Substrat eine UV-härtende Polymerschicht aufgebracht, welche anschliessend mittels physikalischer Abscheidung aus der Gasphase mit zum Beispiel einer Chrom- oder chromähnlichen Schicht beschichtet wird, welche die äusserste Schicht bildet. Dieses Verfahren hat jedoch den Nachteil, dass die äusserste Schicht eine sehr dünne und - da auf weichem Untergrund gelegen - gegenüber mechanischer Einwirkung sehr anfällige PVD-Schicht ist. Für den Einsatz derart beschichteter Komponenten im Exterieurbereich eines Kraftfahrzeuges, bei dem es zu Steinschlag kommt, und die unterschiedlichsten Witterungsverhältnissen ausgesetzt sind, ist diese Art der Beschichtung nicht geeignet.

Es kommt hinzu, dass die Automobilhersteller für diese Art von Komponenten nicht nur das metallische Aussehen vorgeben, sondern auch jeweils einen bestimmten Glanzgrad vorschreiben.

Die europäische Patentanmeldung EP 1 780 311 A1 beschreibt ein Verfahren zum Herstellen seidenmatt glänzender metallischer Oberflächen durch rein galvanische Abscheidung, ohne die Notwendigkeit der Zugabe organischer Additive zum Zwecke der Mattierung.

Der Erfindung liegt daher die Aufgabe zugrunde, ein Verfahren anzugeben, nach dem einer Komponente ein metallisches Aussehen mit vorgegebenem Glanzgrad verliehen wird.

Erfindungsgemäss wird die Aufgabe dadurch gelöst, dass auf die wie auch immer hergestellte metallische Oberfläche eine UV-härtende Lackschicht aufgebracht wird, wobei der für die Herstellung der Lackschicht verwendete Lack eine Mischung ist, die zumindest einen ersten Teil UV-härtenden Glanzlack und einen zweiten Teil UV-härtenden Mattlack umfasst. Dabei gibt der zu erzielende Glanzgrad das Mischungsverhältnis zwischen Glanzlack und Mattlack vor.

Solche UV-härtenden Glanzlacke und UV-härtende Mattlacke sind bekannt und werden beispielsweise durch die Firma Marabu GmbH & Co. KG als UVLG - und UVLM - Lacke vertrieben.

Die Erfindung wird im Anschluss anhand einer Ausführungsform beispielhaft und im Detail erläutert.

Gemäss einer ersten Ausführungsform der vorliegenden Erfindung wird ein Kunststoffsubstrat, welches die Frontverkleidung eines Aussenspiegels bilden soll und dem ein leicht mattiertes verchromtes Aussehen verliehen werden soll, zunächst in einem Ultraschallbad gereinigt und dann getrocknet, beispielsweise unter Zuhilfenahme einer Infrarot-Wärmelampe. Als Kunststoffmaterial kommt beispielsweise PC/ABS in Frage. Anschliessend wird eine 20µm dicke UV-härtende Lackschicht als Basecoat auf zumindest Teile der Oberfläche des Kunststoffsubstrates aufgebracht. Dabei spielt es keine Rolle, ob der UV-härtende Lack ein Glanzlack oder ein Mattlack ist. Die Lösungsmittel entweichen aus der Lackschicht und mittels UV-Strahlung werden die Polymere des Lackes vernetzt. Dieser Basecoat ist im Wesentlichen dazu da, etwaige Rauigkeiten der Oberfläche des ursprünglichen Kunststoffsubstrates auszuglätten.

Nach erfolgter Vernetzung wird die Oberfläche mit einer PVD-Schicht beschichtet. Im Beispiel wird das Kunststoffsubstrat in eine Magnetron-Sputteranlage eingeschleust, welche mit zumindest einem Chromtarget betrieben wird. Enthält die Sputteranlage auch noch Zr und/oder Al-Targets, so können der aufzubringenden Chromschicht durch Beimengung von kleinen Konzentrationen von Zr und/oder Al unterschiedliche, gewünschte Farbnuancen verliehen werden. Im Beispiel wird die im Wesentlichen aus Chrom bestehende PVD-Schicht <1.5 µm dick abgeschieden.

Das Zwischenergebnis ist ein Kunststoffsubstrat, welches aufgrund der <1.5µm dicken äusseren glatten Chromschicht eine metallisch glänzende, jedoch ungeschützte Chromoberfläche aufweist.

Gemäss der hier beschriebenen Ausführungsform der vorliegenden Erfindung wird nun UV-härtender Glanzlack mit UV-härtendem Mattlack in einem Verhältnis von 50%:50% vermischt. Dieser derart gemischte Lack wird als 20 µm dicke Schicht auf die Chromschicht des Kunststoffsubstrates aufgebracht. Die Lösungsmittel lässt man beispielsweise unterstützt durch IR-Strahlung entweichen und die Polymere des gemischten Lackes werden mittels UV-Strahlung vernetzt. Auf diese Weise entsteht ein Kunststoffsubstrat, welches eine zwar metallische, jedoch aufgrund des gemischten Lackes leicht mattierte Oberfläche aufweist. Je nachdem, ob der Kunde einen grösseren oder geringeren Glanzgrad für seine Komponente wünscht, kann das Mischungsverhältnis aus Glanzlack und Mattlack abgeändert werden.

Vorzugsweise wird so vorgegangen, dass eine Matrix unterschiedlicher, mittels des oben beschriebenen Verfahrens hergestellter Muster gebildet wird, wobei in den Spalten der Matrix die Muster unterschiedliche Farbnuancen aufweisen und in den Zeilen der Matrix die Muster unterschiedliche Glanzgrade aufweisen. Diese Matrix kann beispielsweise in einem Koffer verwirklicht sein, so dass die Möglichkeit besteht, die unterschiedlichen Farbnuancen und Glanzgrade unmittelbar zu vergleichen.

Die Erfindung wurde anhand einer auf das Kunststoffsubstrat aufgebrachten PVD-Schicht beschrieben. Es ist jedoch möglich, nahezu jeder beliebigen metallischen bzw. glänzenden Oberfläche einen gewünschten Glanzgrad durch eine entsprechende Mischung des UV-härtenden Lackes (Glanzlack und Mattlack) zu verleihen.

Es wurde ein Verfahren zur Herstellung einer Komponente mit vorgegebenem Glanzgrad offenbart mit den Schritten:
- Bereitstellen einer Komponente mit metallischer Oberfläche
- Herstellen eines Matt-Glanz-Gemisches durch Mischen von Glanzlack und Mattlack in einem vorbestimmten Mischungsverhältnis
- Aufbringen des Matt-Glanz-Gemisches die metallische Oberfläche der Komponente
- Vernetzen des Matt-Glanz-Gemisches.

Beim Glanzlack und/oder beim Mattlack kann es sich um einen UV-härtenden Lack handeln und das Vernetzen des Matt-Glanz-Gemisches kann mittels UV-Strahlung erzielt werden. Zum Bereitstellen der Komponente kann ein Kunststoffsubstrat mit einem Schichtsystem mit mindestens einer metallischen Schicht beschichtet werden. Die Beschichtung kann mittels eines PVD und/oder CVD-Verfahrens und/oder mittels Galvanik aufgebracht werden. Zwischen Schichtsystem und Kunststoffsubstrat wird eine UV-härtende Lackschicht aufgebracht. Das Schichtsystem kann mindestens zwei metallische Schichten umfassen. Das Schichtsystem kann zwei oder mehrere metallische Elemente elementar, in Legierung und/oder in Verbindung umfassen.

Es wurde eine Komponente mit vorgegebenem Glanzgrad offenbart, bei der auf einer metallischen Oberfläche eine Schicht aus einem vernetzten Gemisch aus Glanzlack und Mattlack aufgebracht ist. Die Komponente kann ein Kunststoffsubstrat mit einem Schichtsystem mit mindestens einer metallischen Schicht umfassen. Zwischen dem Schichtsystem und dem Kunststoffsubstrat ist eine UV-härtende Lackschicht vorgesehen. Zumindest einer der Lacke und vorzugsweise alle Lacke können UV-härtende Lacke sein.

## Patentansprüche

1. Verfahren zur Herstellung einer Komponente mit vorgegebenem Glanzgrad mit den Schritten:
- Bereitstellen einer Komponente mit metallischer Oberfläche
- Herstellen eines Matt-Glanz-Gemisches durch Mischen von Glanzlack und Mattlack in einem vorbestimmten Mischungsverhältnis
- Aufbringen des Matt-Glanz-Gemisches auf die metallische Oberfläche der Komponente
- Vernetzen des Matt-Glanz-Gemisches,
wobei zum Bereitstellen der Komponente ein Kunststoffsubstrat mit einem Schichtsystem mit mindestens einer metallischen Schicht beschichtet wird, wobei die Beschichtung mittels eines PVD und/oder CVD-Verfahrens und/oder mittels Galvanik aufgebracht wird, wobei zwischen Schichtsystem und Kunststoffsubstrat eine Lackschicht aufgebracht wird, und wobei die Lackschicht eine UV-härtende Lackschicht ist.

2. Verfahren nach Anspruch 1 , **dadurch gekennzeichnet, dass** es sich beim Glanzlack und/oder beim Mattlack um einen UV-härtenden Lack handelt und das Vernetzen des Matt-Glanz-Gemisches mittels UV-Strahlung erzielt wird.

3. Verfahren nach einem der Ansprüche 1 bis 2, **dadurch gekennzeichnet, dass** das Schichtsystem mindestens zwei metallische Schichten umfasst.

4. Verfahren nach einem der Ansprüche 1 bis 3, **dadurch gekennzeichnet, dass** das Schichtsystem zumindest zwei oder mehrere metallische Elemente elementar, in Legierung und/oder in Verbindung umfasst.

## Claims

1. A method for producing a component with a predetermined gloss level, comprising the steps of:
- preparing a component with a metallic surface;
- producing a matte/glossy mixture by mixing glossy paint and matte paint in a predetermined mixing ratio;
- applying the matte/glossy mixture to the metallic surface of the component
- cross-linking the matte/glossy mixture.
wherein a plastic substrate is coated with a layer system that has at least one metallic layer to provide the component, wherein the coating is applied by means of a PVD and/or CVD process and/or by electroplating, wherein a paint coat is applied between the layer system and the plastic substrate, and wherein the paint coat is a UV-hardening paint coat.

2. The method according to claim 1, **characterized in that** the glossy paint and/or matte paint is a UV-hardened paint and the cross-linking of the matte/glossy mixture is achieved by UV radiation.

3. The method according to one of claims 1 or 2, **characterized in that** the layer system has at least two metallic layers.

4. The method according to one of claims 1 to 3, **characterized in that** the layer system has at least two or more metallic elements in elemental form, in the form of an alloy, and/or in the form of a compound.

## Revendications

1. Procédé de production d'un composant ayant un degré de brillance prédéterminé, comprenant les étapes consistant à :
- préparer un composant avec une surface métallique;
- produire un mélange mat/brillant en mélangeant le vernis brillant et le vernis mat dans un rapport de mélange prédéterminé;
- appliquer le mélange mat/brillant sur la surface métallique du composant;
- réticuler le mélange mat/brillant,
un substrat en matière plastique étant revêtu d'un système de couches qui a au moins une couche métallique pour fournir le composant, le revêtement étant appliqué au moyen d'un procédé PVD et/ou CVD et/ou par galvanoplastie, une couche de vernis étant appliquée entre le système de couches et le substrat en matière plastique, et la couche de vernis étant une couche de vernis durcissant aux UV.

2. Le procédé selon la revendication 1, **caractérisé en ce que** le vernis brillant et/ou le vernis mat est un vernis durci aux UV et la réticulation du mélange mat/brillant est réalisée par rayonnement UV.

3. Le procédé selon l'une quelconque des revendications 1 ou 2, **caractérisé en ce que** le système de couches comporte au moins deux couches métalliques.

4. Le procédé selon l'une quelconque des revendications 1 à 3, **caractérisé en ce que** le système de couches comporte au moins deux ou plusieurs éléments métalliques sous forme élémentaire, sous forme d'alliage et/ou sous forme d'un composé.
